# EUROPÄISCHE PATENTSCHRIFT

(11) **EP 2 633 098 B1**
(45) Veröffentlichungstag und Bekanntmachung des Hinweises auf die Patenterteilung: **16.08.2017**
(21) Anmeldenummer: 11776371.4
(22) Anmeldetag: 27.10.2011
(51) Int. Cl.: C23C 16/52, C23C 16/455, C23C 16/54, C23C 16/44

(54) **GASSCHLEUSE SOWIE BESCHICHTUNGSVORRICHTUNG MIT EINER GASSCHLEUSE**
GAS LOCK, AND COATING APPARATUS COMPRISING A GAS LOCK
ÉCLUSE À GAZ ET DISPOSITIF DE REVÊTEMENT POURVU D'UNE ÉCLUSE À GAZ

(30) Priorität: 27.10.2010 DE 102010049861
(43) Veröffentlichungstag der Anmeldung: 04.09.2013
(73) Patentinhaber: Fraunhofer-Gesellschaft zur Förderung der angewandten Forschung e.V., 80686 München (DE)
(72) Erfinder: POCZA, David, 79117 Freiburg (DE); REBER, Stefan, 79194 Gundelfingen (DE); ARNOLD, Martin, 79194 Gundelfingen (DE); SCHILLINGER, Norbert, 79241 Ihringen (DE)
(74) Vertreter: Pfenning, Meinig & Partner mbB
(86) Internationale Anmeldenummer: PCT/EP2011/005439
(87) Internationale Veröffentlichungsnummer: WO 2012/055561

(56) Entgegenhaltungen:
- DE-A1- 4 313 284
- US-A- 4 354 686
- US-A- 4 438 724
- US-A- 5 919 310
- US-A- 5 968 274

## Beschreibung

Die vorliegende Erfindung betrifft eine Gasschleuse zur Trennung zweier Gasräume, die es ermöglicht, mit minimalem räumlichem Aufwand die Trennung von Gasen ohne Berührung mit dem Produkt/Edukt/Transport-System zu erreichen. Die erfindungsgemäße Gasschleuse zeichnet sich dadurch aus, dass eine Messkammer zur Messung mindestens einer physikalischen und/oder chemischen Eigenschaft integriert ist. Ebenso betrifft die vorliegende Erfindung eine Beschichtungsvorrichtung, die eine erfindungsgemäße Gasschleuse umfasst. Zudem werden Verwendungsmöglichkeiten der erfindungsgemäßen Gasschleuse angegeben.

Zur Kostenreduzierung werden Beschichtungsanlagen mit dem Bestreben konstruiert, kontinuierliche Edukt- und Produktströme zu erzeugen. Auf zahlreichen Gebieten stellt jedoch die Trennung der Prozessgase in der Anlage und die Trennung der Umgebung von den Prozessgasen ein Problem dar.

Bei kontinuierlichen Anlagen, welche auf herkömmliche Dichtungskonzepte verzichten müssen, treten im Wesentlichen folgende Schwierigkeiten auf:
a) Ein Vermischen der Gase aus verschiedenen Prozessschritten muss ausgeschlossen werden, da dies das Produkt unbrauchbar machen würde (beispielsweise kann der Schichtaufbau signifikant beeinflusst und das Produkt zerstört werden).
b) Die meist toxischen und/oder explosiven Prozessgase müssen zuverlässig von der Umgebung getrennt werden, um Sicherheitsrisiken zu vermeiden (Vergiftungen, Explosionen).
c) Die Trennung der Gase muss detektierbar sein, ohne den Druck in toxischen und/oder explosiven Gasen messen zu müssen. Ein Versagen des Dichtungskonzeptes kann so detektiert werden, bevor sich die Prozessgase vermischen oder aus der Anlage strömen (Prozessabbrüche zerstören das Produkt, Ex-geschützte Geräte stellen einen enormen Kostenfaktor im Anlagenbau dar und werden umgangen).
d) Das Konzept muss räumlich kompakt gehalten werden, um die Anlagen wirtschaftlich zu gestalten.
e) Das Konzept darf keine Abnutzung generieren, um die Up-Time der Anlage so hoch wie möglich zu halten und die Produkte nicht zu beschädigen (kein mechanischer Kontakt zum Transportsystem oder dem Produkt).

Bisher wurden die oben genannten Problematiken durch konventionelles Abdichten der Gasräume durch gasdichte Kammern (mittels mechanischen Dichtungen) gelöst. Dies führt jedoch dazu, dass das Transportsystem nicht kontinuierlich funktionieren kann und die Gefahr der Abnutzung oder Beschädigung (siehe Punkt e)) besteht.

Eine weitere Möglichkeit ist das Verwenden von Gasduschen. Hier besteht jedoch das Problem, dass diese in den derzeit üblichen Formen zu ungerichtet sind und keine, für hochreine Prozesse ausreichend tolerante und wirtschaftliche Gastrennung erzeugen. Dies führt zu den oben genannten Problemen a), b) und c) und zu niedriger Up-Time der Anlage.

Die US 5,919,310 beschreibt eine Anlage zur kontinuierlichen Herstellung von Schichten, welche eine Mehrzahl an Reaktionskammern enthält. Die Reaktionskammern sind so angeordnet, dass ein Substratnetz, auf welchem der Film gebildet werden soll, hermetisch unter Vakuumbedingungen durch jede der Reaktionskammern bewegt werden kann. Die Reaktionskammern können durch eine Gasschleuse verbunden sein, wobei der innere Druck der Reaktionskammer mit Druckmessern gemessen werden kann.

In der US 5,968,274 werden ein Verfahren sowie eine Anlage zur kontinuierlichen Herstellung funktioneller abgeschiedener Schichten mit exzellenten Eigenschaften beschrieben. Die Anlage enthält über eine Gasschleuse verbundene Reaktionskammern, wobei in diesen jeweils ein unterschiedlicher Druck vorherrscht. Der Druck kann mit Hilfe von Manometern gemessen werden.

Ausgehend hiervon ist es daher Aufgabe der vorliegenden Erfindung, eine Gasschleuse mit minimalem räumlichem Aufwand zu schaffen, mit der die Funktion der Gasschleuse überprüft werden kann, ohne dazu die Prozessgase in der jeweiligen Kammer analysieren zu müssen. Zudem soll es möglich sein, die Trennung von Gasen ohne Berührung mit dem Produkt/Edukt/Tranport-System zu ermöglichen.

Diese Aufgabe wird bezüglich der Gasschleuse mit den Merkmalen des Patentanspruchs 1 gelöst. Mit Patentanspruch 11 wird eine erfindungsgemäße Beschichtungsvorrichtung bereitgestellt, die eine erfindungsgemäße Gasschleuse umfasst. Mit Patentanspruch 12 werden Verwendungszwecke der erfindungsgemäßen Gasschleuse angegeben. Die abhängigen Patentansprüche stellen dabei vorteilhafte Weiterbildungen dar.

Erfindungsgemäß wird somit eine Gasschleuse zur Trennung zweier Gasräume bereitgestellt, die
a) mindestens einen Einströmkörper, der mindestens zwei Einlasskanäle für ein Gas aufweist, die in eine erste Seite des Einströmkörpers münden,
b) eine beabstandet zur ersten Seite des Einströmkörpers angeordnete Wandung, wobei zwischen der Wandung und dem Einströmkörper ein Spalt, der in fluidischer Verbindung mit den mindestens zwei Einlasskanälen steht, ausgebildet ist,
c) mindestens zwei Ausströmöffnungen für das Gas, die in fluidischer Verbindung mit dem Spalt stehen,
umfasst, wobei in der den Einströmkörper begrenzenden ersten Seite und/oder in der der ersten Seite des Einströmkörpers zugewandten Seite der Wandung n Messkammern zur Messung mindestens einer physikalischen und/oder chemischen Eigenschaft des Gases vorhanden sind, wobei n eine ganze Zahl ≥ 2 ist.

Erfindungsgemäß ist jede Messkammer auf jeder Seite von mindestens einem Einlasskanal flankiert, wobei je zwischen dem mindestens einen, eine Messkammer flankierenden Einlasskanal und dem diesem Einlasskanal benachbarten Einlasskanal, der eine benachbarte Messkammer flankiert, eine Möglichkeit zur Absaugung vorgesehen ist.

Die Wandung kann dabei z.B. als Platte ausgebildet sein. Ebenso ist es möglich, dass die Wandung eine gewisse Krümmung aufweist, beispielsweise die Wandung eines Rohres ist. Der Einströmkörper ist dabei im zuletzt genannten Fall bevorzugt so ausgebildet, dass seine dem Spalt zugewandte Begrenzung ebenso gekrümmt ist, so dass der Spalt an jeder Stelle die gleiche Breite aufweist.

Die Wandung kann dabei bezüglich des Einströmkörpers beweglich ausgebildet sein, so dass z.B. der zwischen Einströmkörper und Wandung befindliche Spalt in seiner Dimension variiert, z.B. verbreitert oder verschmälert werden kann. Z.B. kann die Wandung in Form einer Platte beweglich gegenüber dem Einströmkörper ausgebildet sein; für den Fall, dass der Einströmkörper ringförmig um ein Rohr ausgebildet ist, wobei die äußere Rohrbegrenzung die Wandung darstellt, ist es auch denkbar, dass der Einströmkörper z.B. durch Stellglieder in seinem Umfang variiert werden kann (vertikale Beweglichkeit), so dass dadurch die Breite des Spalts verändert werden kann.

Alternativ oder zusätzlich hierzu ist es ebenso möglich, wenn die Wandung bzw. die Platte in einer Richtung bezüglich des Einströmkörpers beweglich ausgebildet ist, bei der sich die Breite des Spaltes nicht verändert (horizontale Beweglichkeit). Bei einer derartigen Ausgestaltung ist die Wandung in einer Richtung, die 90° zur oben beschriebenen vertikalen Bewegungsrichtung versetzt ist, beweglich ausgebildet.

Zudem ist es möglich, dass die Wandung kontinuierlich ausgebildet ist, ebenso können jedoch auch Unterbrechungen der Wandung vorhanden sein.

Das Prinzip der Erfindung besteht somit darin, dass
- an den zu dichtenden Stellen z.B. Längsspalte geschaffen werden, durch die Inertgas (oder für den Prozess und die Umgebung unkritisches Gas) zugeführt wird, das dem Prozessgas bzw. dem Umgebungsgas entgegenströmt. Die Strömungsgeschwindigkeit bzw. der Partialdruck des Inert- oder unkritischen Gases ist dabei so hoch, dass eine Gegendiffusion des Prozessgases bzw. des Umgebungsgases über die Schleusenlänge innerhalb vorgegebener Grenzen unterbunden wird. Die Gegendiffusion hat einen exponentiellen Verlauf, d.h. man kann sie nur unterdrücken/vermindern, aber streng genommen nicht "unterbinden". De facto werden Verdünnungsverhältnisse > 10⁶ erreicht (auch werthöhere sind möglich), die im technischen Sinn die Ausströmung "unterbinden".
- in der Gasschleuse eine Messkammer, z.B. eine Druckmessstelle etabliert wird, mit deren Hilfe der Druck des Inertgases (oder unkritischen Gases) am Ort der Zuführung (oder in unmittelbarer Umgebung zu dieser) kontrolliert werden kann,
- optional an den jeweiligen Endbereichen der Schleuse weitere Druckmessstellen integriert werden, mit denen der Ausströmdruck aus der Schleuse kontrolliert werden kann,
- optional innerhalb des Spaltes der Schleuse Strömungsfallen (beispielsweise durch Nuten oder Aussparungen) oder Strömungsbrecher (beispielsweise Auswölbungen) geschaffen werden, welche strömungsmechanisch einen Gasrückzug (beispielsweise durch Jet-Effekte) unterbinden und dadurch die erforderliche Schleusenlänge reduzieren können,
- die Gasschleuse doppelt oder mehrfach ausgelegt ist und durch eine oder mehrere vorhandene Absaugvorrichtungen die Trennwirkung erhöht wird,
- optional können geeignete Einbauten einen z.B. turbulenten Bereich erzeugen, mit dem gezielt Druckstufen in der Schleuse etabliert werden können.

Ein Überprüfen der Schleusenfunktion wird möglich, indem überprüft wird, ob der Ausströmdruck des Inertgases oder unkritischen Gases höher ist als der an den Schleusenenden gemessene Druck. Aus dem Stand der Technik ist bislang lediglich die Möglichkeit bekannt, den Druck direkt in den zu trennenden Prozesskammern zu ermitteln, wodurch jedoch das eingangs angesprochene Problem c) auftritt.

Die erfindungsgemäße Gasschleuse löst bzw. beseitigt alle oben genannten Probleme a) bis e). Sie stellt die Grundlage für Anlagen dar, deren Transportsystem kontinuierlich arbeitet und deren Gasräume voneinander getrennt sind. Die Erfindung ermöglicht ein Überwachen der Gasschleuse und die Minimierung deren räumlicher Ausdehnung. Dadurch ist eine optimale Prozess- und Sicherheitskontrolle gegeben. Ferner ist es mit der Erfindung möglich, eine Anlage welche kontinuierlich betrieben wird und/oder mit toxischen und/oder explosiven Gasen arbeitet, in einer normalen Arbeitsumgebung zu installieren. Dabei können alle sicherheitsrelevanten Kriterien eingehalten werden und die Anlagenkosten reduziert werden.

Eine bevorzugte Ausführungsform sieht vor, dass in der den Einströmkörper begrenzenden ersten Seite und/oder in der der ersten Seite des Einströmkörpers zugewandten Seite der Wandung mindestens eine weitere, bevorzugt mindestens zwei weitere Messkammern zur Messung mindestens einer physikalischen und/oder chemischen Eigenschaft des Gases (z.B. Druck und/oder Temperatur oder die chemische Zusammensetzung) vorhanden ist.

Ferner ist bevorzugt, dass die den Einströmkörper begrenzende erste Seite und/oder die der ersten Seite des Einströmkörpers zugewandte Seite der Wandung mindestens eine, bevorzugt eine Mehrzahl von der ersten Seite des Einströmkörpers ausgehende und in diesen hineinragende bzw. von der der ersten Seite des Einströmkörpers zugewandten Seite der Wandung ausgehende und in die Wandung hineinragende Aussparungen aufweist. Die Aussparungen können beispielsweise als Vertiefungen des Einströmkörpers bzw. in der Wandung ausgebildet sein.

Alternativ oder zusätzlich hierzu kann die den Einströmkörper begrenzende erste Seite und/oder die der ersten Seite des Einströmkörpers zugewandte Seite der Wandung mindestens eine, bevorzugt eine Mehrzahl von der ersten Seite des Einströmkörpers ausgehende und in den Spalt hineinragende bzw. von der der ersten Seite des Einströmkörpers zugewandten Seite der Wandung ausgehende und in den Spalt hineinragende Erhebungen aufweisen. Diese Erhebungen können als Gegenstück zu den oben angesprochenen Aussparungen ausgebildet sein.

Diese beiden speziellen Ausgestaltungen ermöglichen es, innerhalb des Spaltes Verwirbelungen beim Durchströmen des Inertgases zu erzeugen, so dass eine Effizienzsteigerung der Sperrwirkung der Gasschleuse und so eine Verkürzung der Baulänge erzielt werden kann.

Insbesondere ist es vorteilhaft, wenn mindestens eine Aussparung und mindestens eine Erhebung in Kombination miteinander vorhanden sind.

Eine weiter bevorzugte Ausführungsform der Gasschleuse sieht vor, dass der Einströmkörper mindestens zwei Einlasskanäle aufweist, wobei die Messkammer zwischen den beiden Einlasskanälen angeordnet ist.

Die Gasschleuse kann bezüglich der Messkammer spiegelsymmetrisch aufgebaut sein. Eine spiegelsymmetrische Ausbildung der Gasschleuse sieht beispielsweise vor, dass die Ausströmöffnungen so angeordnet sind, dass die Ausströmrichtung der ersten Ausströmöffnung der Ausströmrichtung der zweiten Ausströmöffnung entgegengesetzt ist.

In einer weiter bevorzugten Ausführungsform kann die Gasschleuse rotationssymmetrisch ausgebildet sein. In einer derartigen Ausführungsform ist die Gasschleuse ringförmig um einen zylindrischen Körper angeordnet. Dabei dient die Oberfläche des zylindrischen Körpers als Wandung. Der zylindrische Körper kann dabei beispielsweise ein Rohr sein, das im Inneren hohl ist.

Ebenso ist es möglich, dass die Gasschleuse beide Symmetrieformen aufweist, d.h. sowohl spiegelsymmetrisch, beispielsweise bezüglich der Messkammer, als auch rotationssymmetrisch, d.h. beispielsweise auf einem Rohr, wobei die Rohroberfläche als Wandung dient, ausgebildet ist. Zwischen der Wandung und dem Einströmkörper ist dabei ein ringförmiger Spalt, der um den zylindrischen Körper verläuft, ausgebildet, durch den das Gas strömen kann.

Bevorzugt ist außerdem, dass der Spalt im Wesentlichen lotrecht zum mindestens einen Einlasskanal verläuft. Ebenso sind jedoch gewinkelte Verläufe denkbar.

In der erfindungsgemäßen Gasschleuse ist vorgesehen, dass mindestens eine Möglichkeit zum Absaugen von Gas vorhanden ist.

Hierbei ist vorgesehen, dass der Einströmkörper mindestens zwei Einlasskanäle für ein Gas aufweist und der Spalt in fluidischer Verbindung mit den mindestens zwei Einlasskanälen steht, wobei in der den Einströmkörper begrenzenden ersten Seite und/oder in der der ersten Seite des Einströmkörpers zugewandten Seite der Wandung mindestens zwei Messkammern zur Messung mindestens einer physikalischen und/oder chemischen Eigenschaft des Gases vorhanden sind.

Erfindungsgemäß sind n Messkammern vorhanden, wobei n eine ganze Zahl ≥ 2 ist, wobei die Messkammern bevorzugt äquidistant angeordnet sind und jede Messkammer auf jeder Seite von mindestens einem Einlasskanal flankiert ist. Diese Ausführungsform entspricht einer iterativen Anordnung mehrerer oben beschriebener einzelner Gasschleusen mit jeweils nur einer Messkammer. Die oben beschriebenen bevorzugten Ausführungsformen gelten uneingeschränkt auch für diese mehrfache Ausführung der Gasschleuse.

Ferner ist bevorzugt, dass auf der dem Einströmkörper abgewandten Seite der Wandung mindestens ein weiterer Einströmkörper angeordnet ist oder eine Mehrzahl von abwechselnd angeordneten Einströmkörpern und Wandungen angeordnet ist. Diese Ausführungsform sieht vor, dass auch in vertikaler Richtung eine Aufteilung der Schleuse in mehrere Teilgasschleusen vorgenommen werden kann.

Erfindungsgemäß wird ebenso eine Beschichtungsvorrichtung oder eine Wärmebehandlungsvorrichtung beansprucht, die mindestens eine zuvor beschriebene Gasschleuse umfasst. Die Beschichtungsvorrichtung umfasst dabei zwei Gasräume, die von der erfindungsgemäßen Gasschleuse getrennt sind, d.h. die Gasschleuse ist zwischen den Gasräumen angeordnet.

Erfindungsgemäß werden ebenso Verwendungszwecke der erfindungsgemäßen Gasschleuse angegeben. Insbesondere eignet sich diese zur Aufrechterhaltung eines bestehenden Konzentrationsgradienten eines und/oder mehrerer Gase und/oder zur Aufrechterhaltung einer Separierung verschiedener Gase zwischen zwei Gasräumen.

Die vorliegende Erfindung wird anhand der nachfolgenden Figuren näher erläutert, ohne die Erfindung auf die dargestellten speziellen Ausgestaltungen zu beschränken.

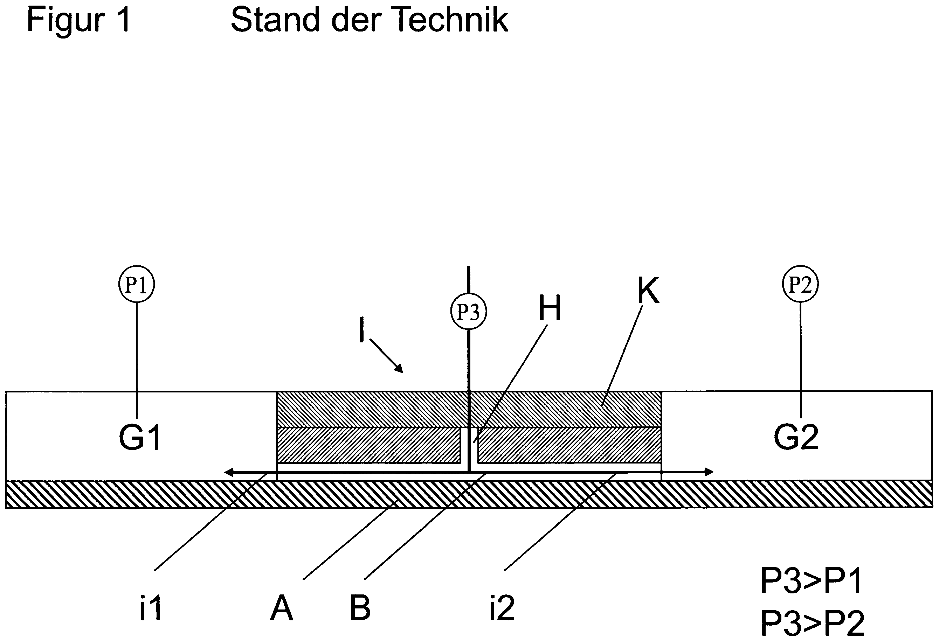

In Figur 1 ist eine aus dem Stand der Technik bekannte Gasschleuse dargestellt. Die Gasschleuse I dient dabei der Trennung zweier Gasräume G1 und G2 und ist insofern zwischen diesen Gasräumen angeordnet. Umfasst ist ein Einströmkörper K, der einen mittig im Einströmkörper K angeordneten Einlasskanal H aufweist. Gegenüber dem Einströmkörper K ist eine als Platte A ausgebildete Wandung angeordnet, so dass zwischen der Platte A und dem Einströmkörper K ein Spalt B ausgebildet wird. Mit i1 und i2 werden die jeweiligen Ausströmöffnungen, die sich an den Ausgängen der Gasschleuse I zu den Gasräumen G1 und G2 befinden, bezeichnet. Das Inertgas/unkritische Gas i1 bzw. i2 strömt den Gasräumen G1 bzw. G2 entgegen.

Mit P1 und P2 sind die jeweiligen Gasdrücke in den jeweiligen Gasräumen G1 und G2 bezeichnet. P3 ist der Druck des Inertgases innerhalb der Zuleitung des Schleusengases.

In dieser Anordnung kann keine präzise Messung des Ausströmdrucks (Druck P3) in der Zuleitung des Inertgases/unkritischen Gases im Spalt B erfolgen. Die Drücke am "Gasschleusenauslass" i1, i2 können lediglich in den Gasräumen G1 bzw. G2 direkt gemessen werden. Die Gasschleuse funktioniert umso effektiver, je höher P3 gegenüber P1 bzw. P2 ist. Diese Gasschleuse wird, wie es auch schon in der Figur angedeutet ist, derart betrieben, dass der Druck des einströmenden Gases P3 größer sein muss als die in den jeweiligen Gasräumen G1 und G2 vorherrschenden Drücke P1 und P2. Allerdings kann in dieser Ausführungsform der Druck des Inertgases P3, der zur effizienten Aufrechterhaltung beispielsweise eines Gradienten der chemischen Zusammensetzung der Gase in den Gasräumen G1 und G2 benötigt wird, nur grob abgeschätzt werden. Diese Schleuse lässt sich nur sehr ungenau betreiben.

Diese grundlegenden, zur Figur 1 gemachten Ausführungen (z.B. die Bezugszeichen) gelten uneingeschränkt auch für die nachfolgend dargestellten erfindungsgemäßen Ausführungsformen.

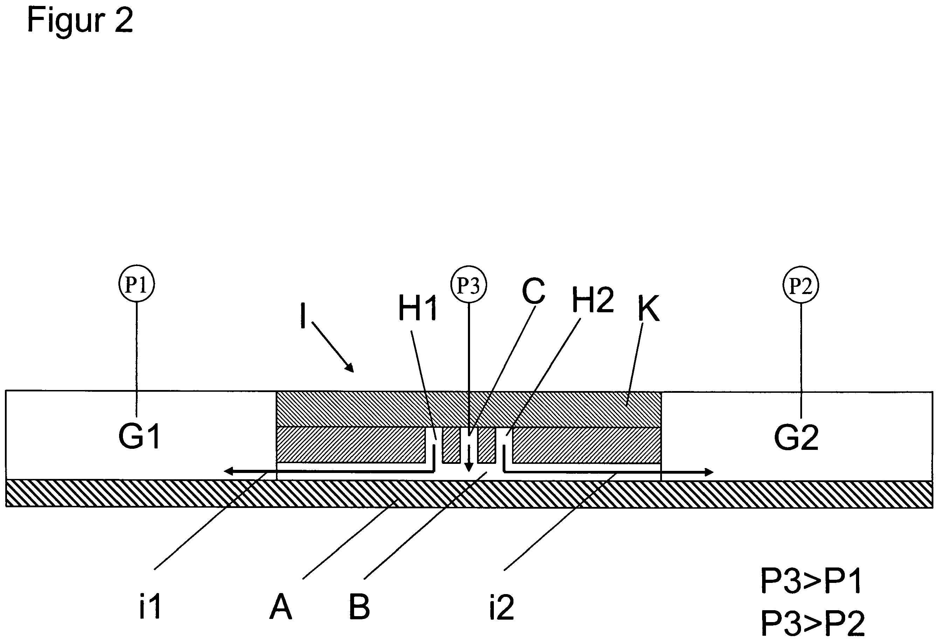

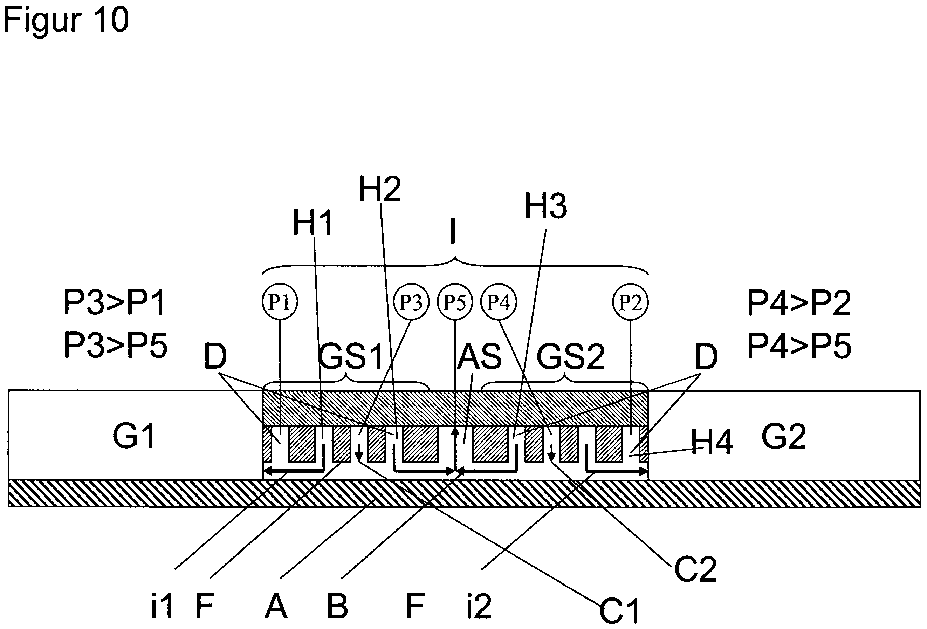

Die Figuren 10 bis 12 stellen erfindungsgemäße Ausführungsformen einer Gasschleuse dar. In Figur 2 ist die prinzipielle Ausführungsform der einer Gasschleuse dargestellt.

Die Anordnung unterscheidet sich zur oben beschriebenen Ausführungsform des Standes der Technik gemäß Figur 1 durch die zusätzliche Messkammer C. Hier ist eine separate Messkammer für den Ausströmdruck des Inert- oder unkritischen Gases in die Gasschleuse eingebracht, welche zusätzlich (optional) mit Inertgas (oder unkritischem Gas) gespült werden kann. Weiterhin sind zwei Einlasskanäle H1 und H2 vorgesehen, die die Messkammer C flankieren. Die hier dargestellte Ausführungsform ist spiegelsymmetrisch bezüglich der Messkammer C aufgebaut.

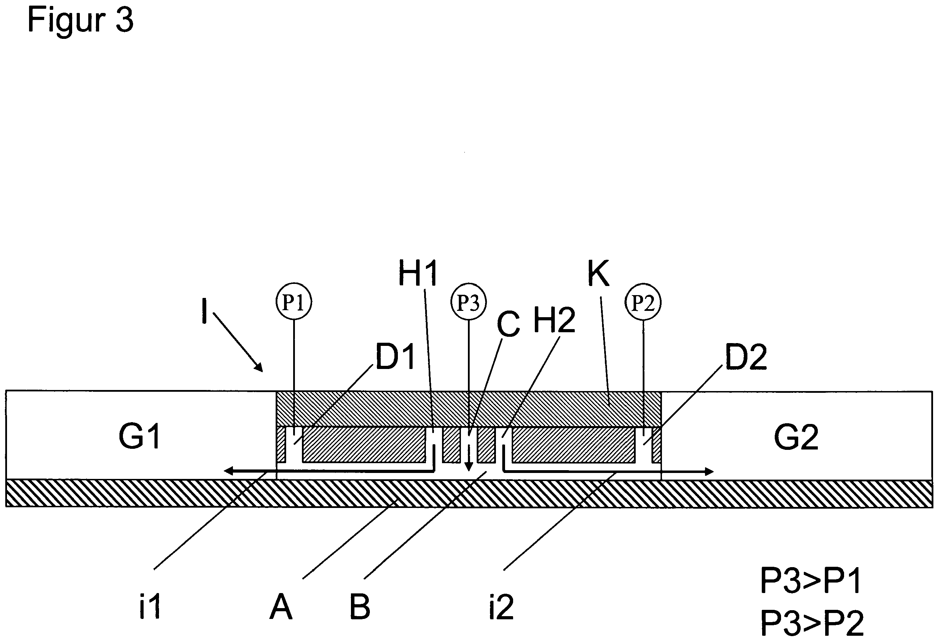

In Figur 3 ist eine weitere Ausführungsform einer Gasschleuse dargestellt. Die Anordnung unterscheidet sich zur Ausführungsform gemäß Figur 2 durch beidseitig angeordnete zusätzliche Messkammern D1 und D2 für die Messung der ausgangsseitigen Gasschleusendrücke P1 und P2. Hier sind separate Messkammern in die Gasschleuse eingebracht, welche zusätzlich (optional) mit Inertgas (oder unkritischem Gas) gespült werden können. Diese Konstruktion beseitigt insbesondere das eingangs erwähnte Problem c).

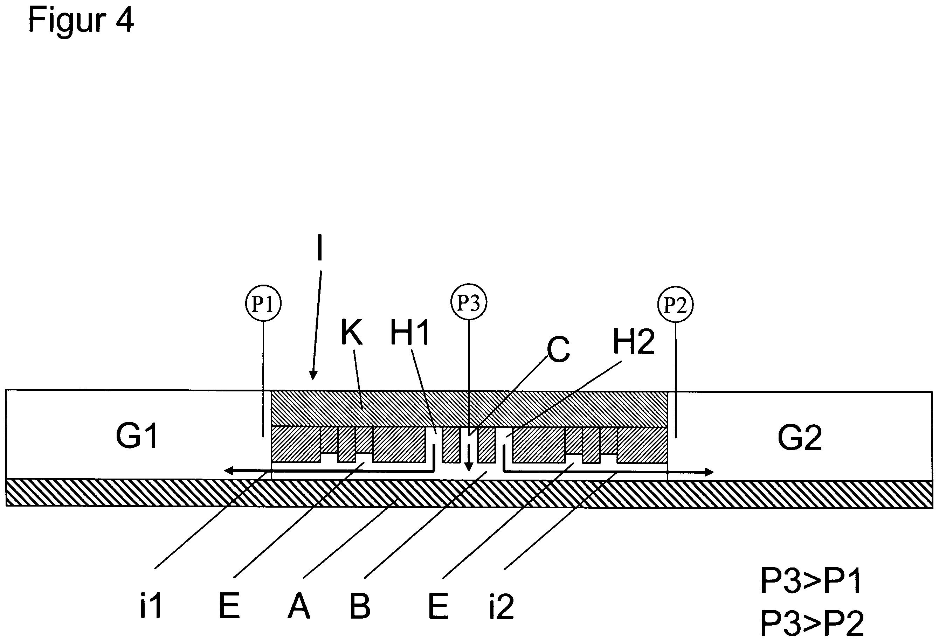

Eine weitere Ausführungsform einer Gasschleuse ist in Figur 4 dargestellt. Diese Ausführungsform unterscheidet sich von der in Figur 2 dargestellten Ausführungsform, dass zusätzlich eine oder mehrere (im vorliegenden Fall vier) Aussparungen E in die Unterseite des Einströmkörpers K eingebracht sind, wobei diese jeweils die Einströmkanäle H1 und H2 flankieren. Diese Aussparungen E können beispielsweise in Form von Einkerbungen oder Vertiefungen in der Oberfläche des Einströmkörpers K ausgebildet sein. Im Falle einer spiegelsymmetrischen Ausbildung der Gasschleuse sind die Einkerbungen E parallel zueinander verlaufend, beispielsweise in Querrichtung zu den jeweiligen mit den Pfeilen angedeuteten Hauptströmungsrichtungen des Inertgases ausgebildet. Die Aussparungen E können sowohl vom Einströmkörper K als auch der Platte A (nicht dargestellt) aus erfolgen. Diese fungieren als Strömungsfallen und unterbinden einen Gasrücktransport unter turbulenten oder kritischen Betriebsbedingungen. Zusätzlich kann durch eine solche Konstruktion die Schleusenlänge (Länge des Spaltes B in Richtung der jeweiligen Gasräume G1 und G2) minimiert werden.

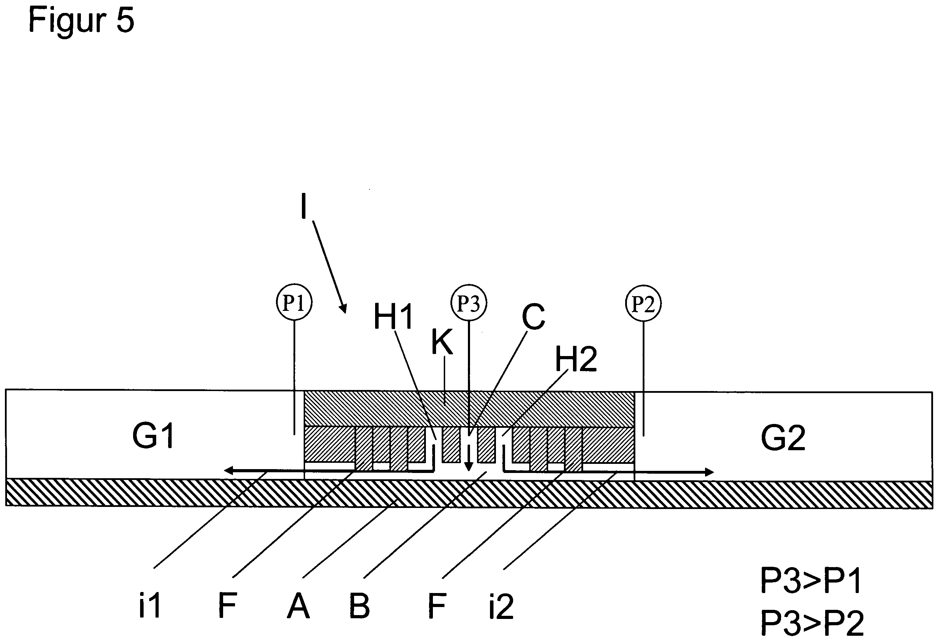

In Figur 5 ist das umgekehrte Konzept zur Ausführung gemäß Figur 4 dargestellt. Anstelle der in Figur 4 dargestellten Aussparungen E weist die Ausführungsform gemäß Figur 5 von der Unterseite des Einströmkörpers K ausgehende und in den Spalt B hinein ragende Erhebungen F auf. Dies kann sowohl vom Einströmkörper K als auch der Platte A aus erfolgen. Diese funktionieren als Strömungsbrecher und verhindern einen Gasrücktransport unter turbulenten oder kritischen Betriebsbedingungen. Zusätzlich kann durch eine solche Konstruktion die Schleusenlänge minimiert werden.

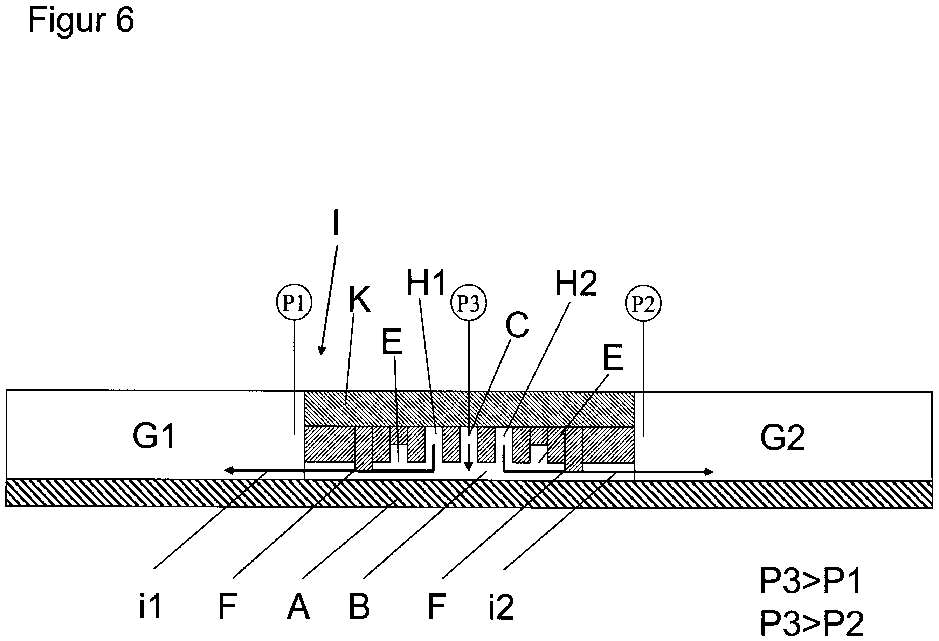

Figur 6 betrifft eine Kombination der in den Figuren 4 und 5 dargestellten Maßnahmen. Die hier dargestellte Gasschleuse I weist einen Einströmkörper K auf, der sowohl Aussparungen E als auch Erhebungen F aufweist. Ebenso ist die Möglichkeit gegeben, dass die Aussparungen E und Erhebungen F in der Platte A ausgebildet sein können (nicht dargestellt).

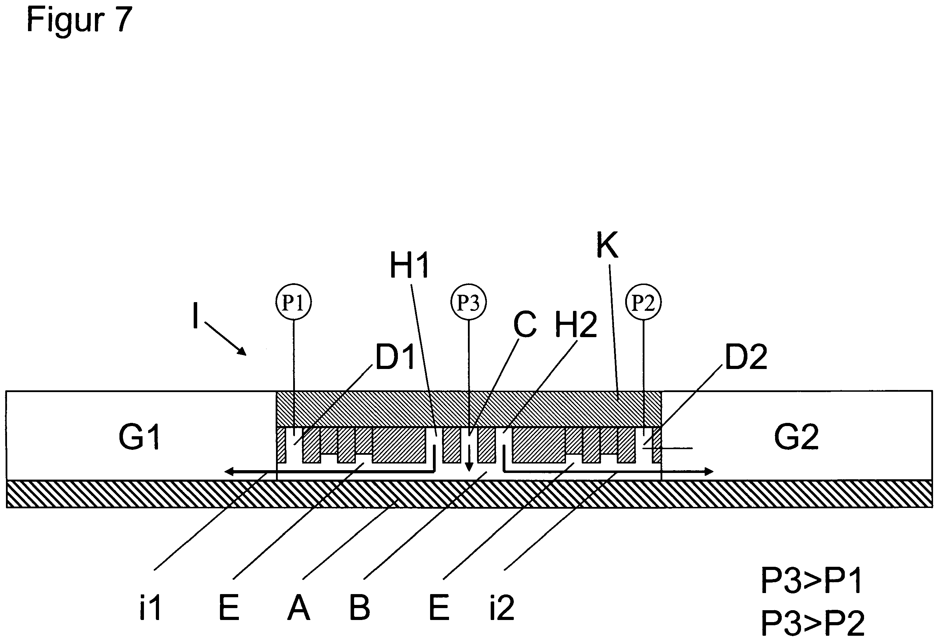

In Figur 7 ist eine spezielle Gasschleuse I dargestellt, die sowohl zusätzliche Messkammern D1 und D2 aufweist (diese Ausführungsform wurde eingehend in Figur 3 dargestellt) sowie zusätzlich auf der Unterseite des Einströmkörpers K mehrere Aussparungen E, wie dies in Zusammenhang mit der Ausführungsform der Figur 4 beschrieben wurde. Die in Figur 7 dargestellte Ausführungsform der Gasschleuse I ist somit eine Kombination der in den Figuren 3 und 4 dargestellten Ausführungsformen. Die Aussparungen E können sowohl vom Einströmkörper K als auch der Platte A aus erfolgen. Diese funktionieren als Strömungsfallen und unterbinden einen Gasrücktransport unter turbulenten oder kritischen Betriebsbedingungen. Zusätzlich kann durch eine solche Konstruktion die Schleusenlänge minimiert werden.

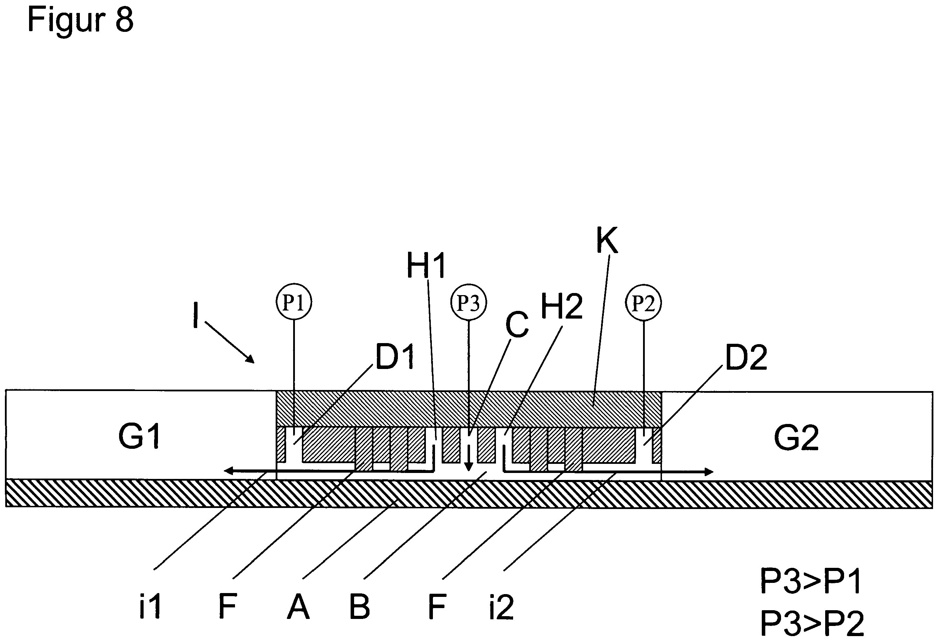

Figur 8 zeigt eine weitere Ausführungsform der Gasschleuse I, die eine Erweiterung der bereits in Figur 5 dargestellten Gasschleuse um die beiden zusätzlichen Messkammern D1 und D2 betrifft. Somit weist der Einströmkörper K auf der Unterseite eine Mehrzahl von Erhebungen F auf. Diese hier dargestellte Ausführungsform ist somit eine Kombination der in den Figuren 3 und 5 dargestellten technischen Merkmale. Die Erhebungen F können sowohl vom Einströmkörper K als auch der Platte A aus erfolgen. Diese funktionieren als Strömungsbrecher und verhindern einen Gasrücktransport unter turbulenten oder kritischen Betriebsbedingungen. Zusätzlich kann durch eine solche Konstruktion die Schleusenlänge minimiert werden.

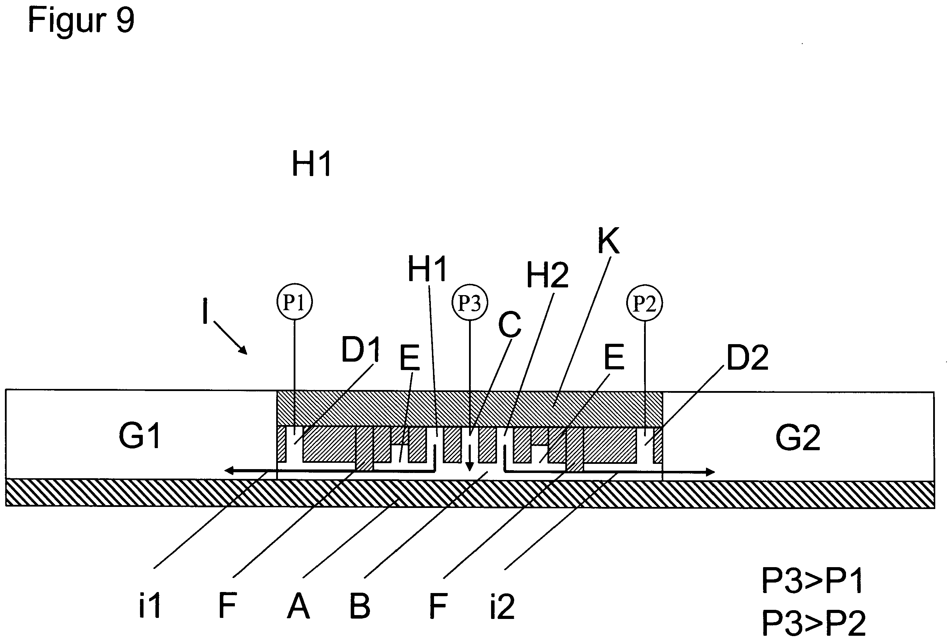

In Figur 9 ist eine weitere spezielle Ausgestaltung einer Gasschleuse I dargestellt, die neben zusätzlichen Messkammern D1 und D2 sowohl die bereits im Voranstehenden im Detail erläuterten Erhebungen F sowie Aussparungen E im Einströmkörper K aufweist. Diese hier dargestellte Ausführungsform stellt somit eine Kombination der Ausführungsformen gemäß den Figuren 3 und 6 dar.

In Figur 10 ist eine erfindungsgemäße Gasschleuse I ausgeführt, die aus zwei Teilgasschleusen GS1 und GS2 gebildet ist. Diese beiden Teilgasschleusen GS1 und GS2 sind dabei im Wesentlichen analog einer einzelnen Gasschleuse gemäß einer Ausführungsform der Figur 3 ausgebildet und werden aneinander gereiht, um die gesamte Gasschleuse I zu bilden. Diese Ausgestaltung der beiden Teilgasschleusen GS1 und GS2 ist jedoch lediglich beispielhafter Natur, ebenso können diese beiden Teilgasschleusen GS1 und/oder GS2 gemäß einer beliebigen, in den voranstehenden Figuren dargestellten Ausführungsform ausgebildet sein und somit auch die oben angesprochenen Strömungsbrecher, z.B. in Form von Erhebungen oder Aussparungen umfassen. Zwischen den beiden Teilgasschleusen GS1 und GS2 ist eine Absaugmöglichkeit AS vorgesehen, über die zugeführtes Gas abgesaugt werden kann. Die beiden Teilgasschleusen GS1 und GS2 verfügen dabei jeweils über separate Gaszuführungen H1 und H2 (bei GS1) bzw. H3 und H4 (bei GS2). Im Betrieb einer derartigen Gasschleuse I gilt für die Drücke, die in den jeweiligen Regionen der Gasschleuse bzw. den zwei Gasräumen G1 und G2 vorherrschen, P3>P1, P3>P5, P4>P2 und P4>P5, wobei die Messstellen der Drücke in der Gasschleuse I mit den eingekreisten Bezugszeichen versehen sind.

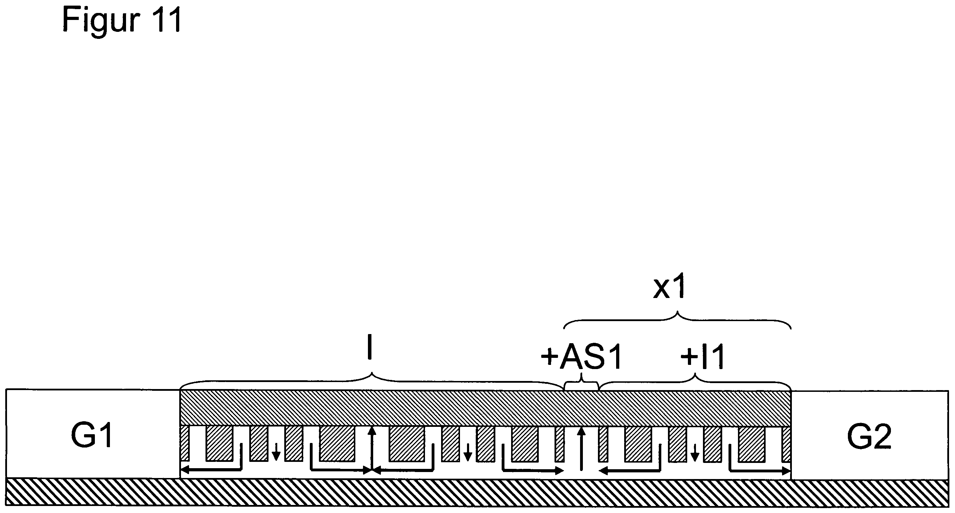

In Figur 11 ist ein weiteres Konzept einer erfindungsgemäßen Gasschleuse I dargestellt, die in dieser speziellen Ausführungsform drei aneinander gereihte Teilgasschleusen, wie sie auch in Figur 10 dargestellt sind, umfasst. Zur Wahrung der Übersichtlichkeit wurde bei der Darstellung in Figur 11 auf die Bezugszeichen verzichtet, die Ausgestaltung der hier dargestellten Gasschleuse entspricht jedoch prinzipiell der in Figur 10 dargestellten Bauweise. Im Gegensatz zur Ausgestaltung gemäß Figur 10 mit zwei Teilgasschleusen ist bei der Ausgestaltung gemäß Figur 11 (mit drei Teilgasschleusen) eine zweite Absaugmöglichkeit zur Abführung von Gas AS vorgesehen.

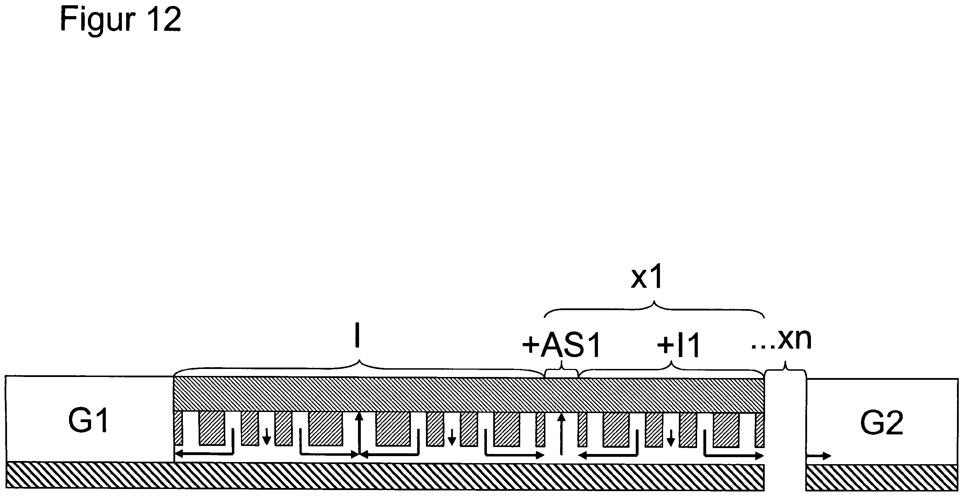

Figur 12 stellt eine weitere Ausführungsform der Erfindung dar, wobei hier eine Gasschleuse I dargestellt ist, die eine n-fache Aneinanderreihung von Teilgasschleusen umfasst. Zwischen jedem der vorhandenen Teilgasschleusen ist eine Absaugmöglichkeit AS für Gas vorgesehen. Die hier dargestellte Ausführungsform stellt die logische Erweiterung der in Figuren 10 bzw. 11 dargestellten Ausführungsformen um n weitere Teilgasschleusen dar.

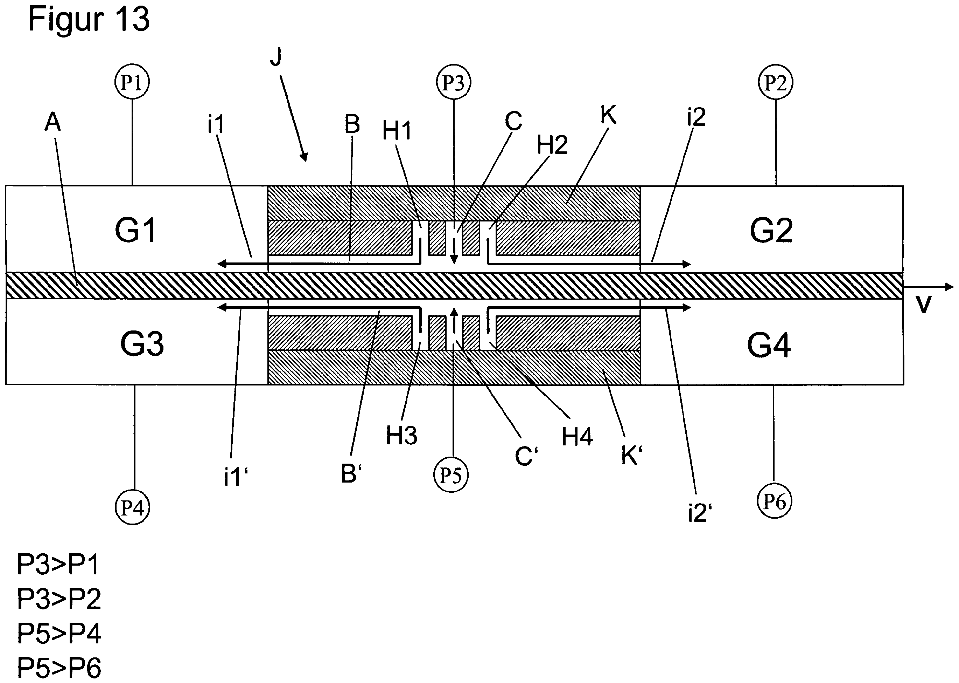

In Figur 13 ist eine weitere Gasschleuse dargestellt, die im Gegensatz zu den voranstehenden Ausführungsformen der Gasschleuse anstelle eines einzelnen Einlasskörpers zwei Einlasskörper K und K' aufweist, wobei diese Einlasskörper durch eine Platte A voneinander getrennt sind. Die jeweiligen Einlasskanäle H1 und H2 bzw. H3 und H4 münden dabei jeweils in Richtung auf die zwischen den beiden Einlasskörpern K und K' liegende Platte 4. Insofern betrifft diese Ausführungsform eine um einen weiteren Einlasskörper erweiterte Ausführungsform gemäß Figur 2. Die beiden Einlasskörper K und K' müssen dabei nicht, wie in Figur 13 dargestellt, symmetrisch bezüglich der Platte A beabstandet angeordnet sein, es ist auch eine asymmetrische Beabstandung der beiden Einlasskörper K von der Platte A möglich. Die sonstigen Bezugszeichen sind denen der Figur 2 entlehnt, wobei die in der zusätzlichen Gasschleuse, die durch den Einströmkörper K' und die Platte A gebildet wird, mit einem Strich versehen sind. Dabei kann die zwischen den beiden Einströmkörper K und K' liegende Platte A beweglich ausgebildet sein. Diese kann, wie in der Figur rechts durch v angedeutet, beispielsweise horizontal beweglich führbar sein. Zusätzlich oder alternativ hierzu ist jedoch ebenso eine vertikale Beweglichkeit der Platte A denkbar, so dass beispielsweise die Breite eines der beiden Spalte B oder B' auf 0 reduziert und somit eine Gasschleuse verschlossen werden kann. Durch diese in Figur 13 dargestellte Gasschleuse ist eine Abtrennung von insgesamt
vier Gasräumen G1 bis G4 voneinander möglich. Die entsprechenden Druckverhältnisse, die bei Betrieb der Gasschleuse herrschen müssen, sind wie auch schon in den voranstehenden Figuren mit dem jeweiligen Referenzzeichen P1 bis P6 angegeben, wobei die jeweiligen idealen Drücke in der Figur dargestellt sind.

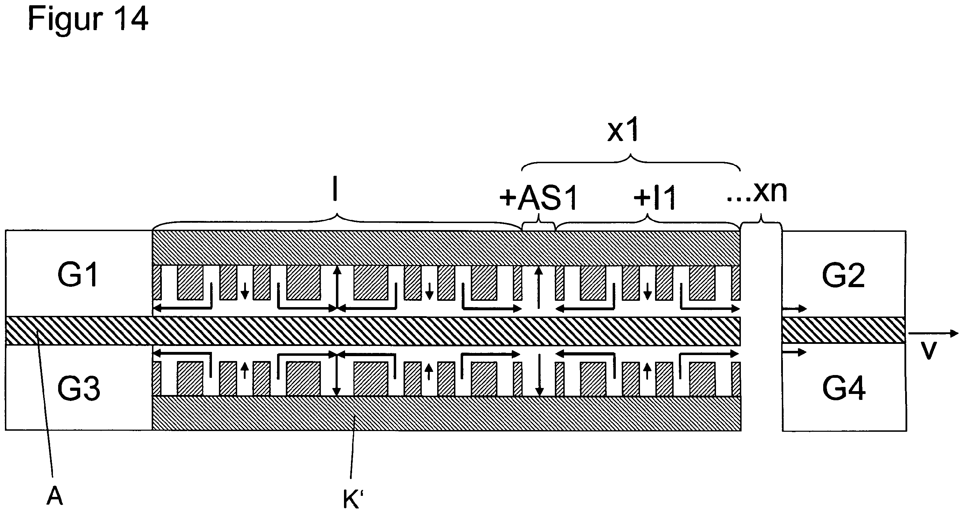

Die Ausführungsform der Gasschleuse, bei der mehrere Einlasskörper K, K', ..., Kn vorhanden sind, kann auf jedes der in Figur 1 bis 12 dargestellten Schleusenprinzipien übertragen werden. Lediglich als Beispiel hierfür zeigt Figur 14 eine weitere Ausgestaltung eine weitere Ausgestaltung einer erfindungsgemäßen Gasschleuse I, die einer Verdoppelung der in Figur 12 dargestellten Gasschleuse entspricht, wobei ein weiterer Einströmkörper K' mit den entsprechenden Ausgestaltungen (d.h. auch hier sind beispielsweise Absaugmöglichkeiten vorhanden etc.), ausgebildet ist. Der Übersichtlichkeit halber sind auch hier die jeweiligen Bezugszeichen nicht im Detail aufgeführt; es wird hierzu auch auf die Ausführungen zur Figur 12 verwiesen. Die zwischen den beiden Einströmkörpern K und K' angeordnete Platte A kann gemäß den Ausführungsformen der Figur 13 ausgebildet sein.

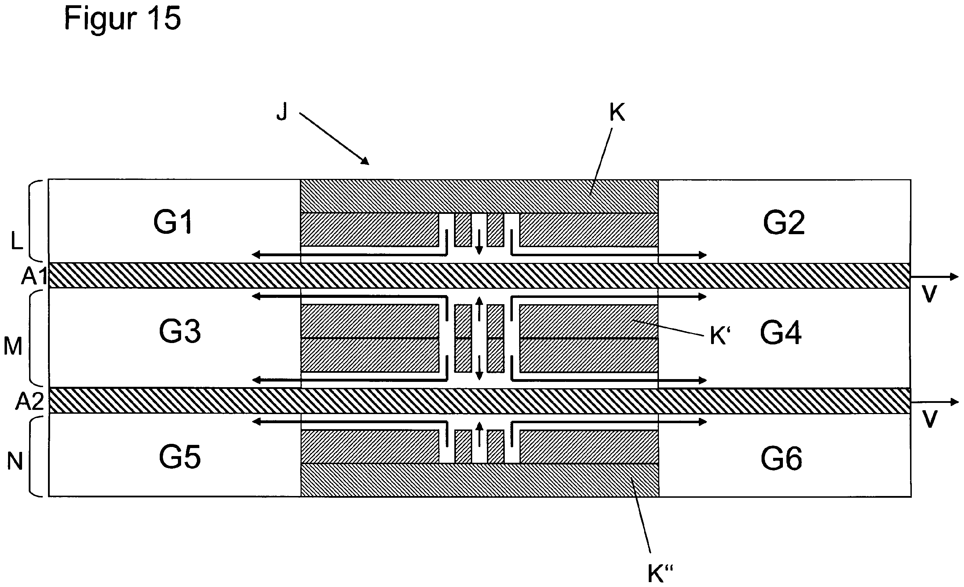

Das in Figur 13 angesprochene Konzept einer Gasschleuse, die mehr als einen Einströmkörper K aufweist, ist ebenso, wie in Figur 15 in einer speziellen Ausgestaltungsform näher erläutert, um eine vertikale Dimension beliebig erweiterbar. Hier ist eine Gasschleuse I dargestellt, die aus drei Teilgasschleusen L, M und N aufgebaut ist. Die Teilgasschleuse L mit einem Einströmkörper K ist dabei der in Figur 2 dargestellten Ausführungsform nachempfunden. Der Übersichtlichkeit halber wird auch in dieser Figur auf die näheren Bezugszeichen verzichtet; die Gasschleusen sind dabei allesamt wie in Figur 2 dargestellt ausgebildet. Die Teilgasschleuse L mit dem Einströmkörper K wird durch eine beweglich angeordnete Platte A1 begrenzt. An die Platte A1 schließt sich die zweite Teilgasschleuse M an, die zwischen den Teilgasschleusen L und N gelegen ist. Diese Teilgasschleuse wird auf der einen Seite durch die Platte A1, auf der anderen Seite durch die Platte A2 begrenzt. Auch die Platte A2 ist dabei beweglich ausgebildet, gemäß der Darstellung in der Figur in horizontaler Richtung. Der Einströmkörper K' der Teilgasschleuse M ist dabei so ausgebildet, dass er Auslasskanäle auf beiden Seiten aufweist, d.h. Auslasskanäle in Richtung der Platte A1 und der Platte A2. Die Teilgasschleuse N ist durch einen Einströmkörper K" gebildet, der spiegelsymmetrisch zur ersten Teilgasschleuse L ausgebildet ist.

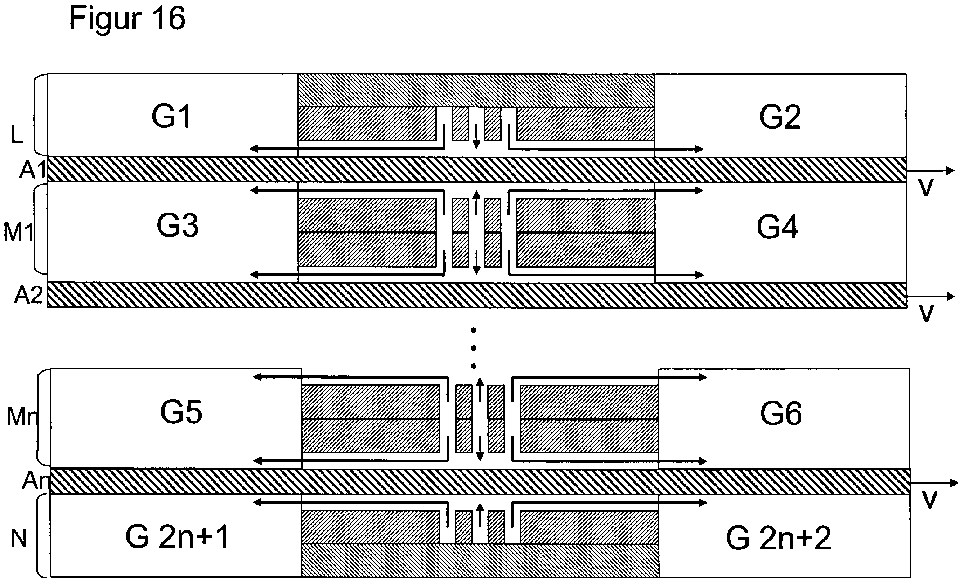

Figur 16 zeigt schließlich die Erweiterung des in Figur 15 vorgestellten Konzepts in Form einer multiparallelen Mehrfachschleuse für n bewegliche Platten A1...An. Anstelle einer einzelnen Teilgasschleuse M, die zwischen zwei terminierenden Teilgasschleusen L und N beinhaltet ist, wie dies in Figur 15 dargestellt ist, weist die Ausführungsform gemäß Figur 16 n verschiedene Teilgasschleusen auf, die jeweils durch eine Platte A voneinander separiert sind. Die die Teilgasschleuse M1...Mn bildenden Einströmkörper sind dabei dem Einströmkörper K' der Teilgasschleuse gemäß Figur 15 nachempfunden. Diese Ausführungsform ermöglicht die Separierung von insgesamt bis zum G2n verschiedenen Gasräumen. Die weiteren Details einer derartigen multiparallelen Mehrfachschleuse, insbesondere hinsichtlich der Beweglichkeit der Platten A ist bereits in den Figuren 13 bis 15 ausführlich beschrieben.

Selbstverständlich ist ebenso die Möglichkeit gegeben, dass die in den Figuren 13 bis 16 dargestellten Schleusen gemäß einer der in den Figuren 3 bis 12 dargestellten Ausführungsformen gestaltet sind.

Bei allen zuvor gemachten Ausführungen kann die Platte A bezüglich des Einströmkörpers oder der Einströmkörper in fixiertem Abstand angeordnet, aber auch beweglich ausgebildet sein, so dass eine Variation der Spaltbreite und/oder eine Variation der horizontalen Position der Wandung relativ zum Einströmkörper möglich ist.

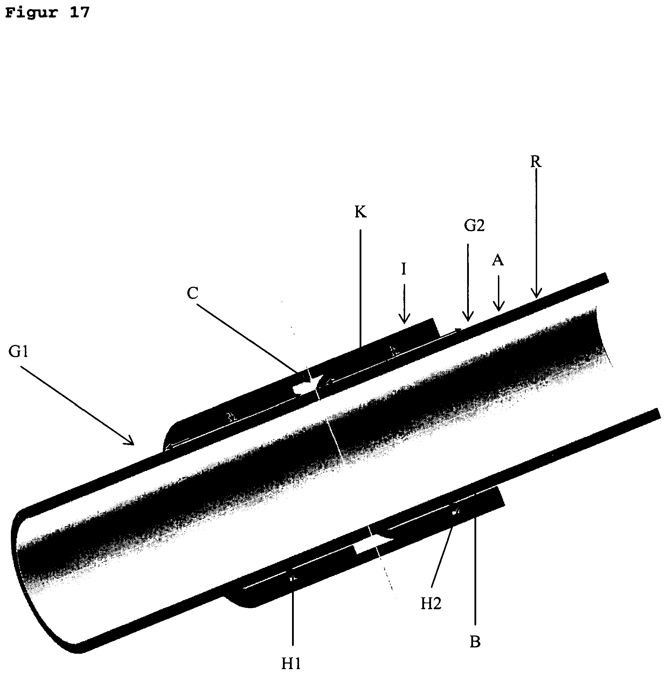

Figur 17 zeigt eine rotationssymmetrische Ausbildung der Gasschleuse. Hierbei ist die Gasschleuse I durch einen rotationssymmetrisch ausgebildeten Einströmkörper K, der um ein Rohr R angeordnet ist, gebildet. Dabei dient die äußere Wandung A des Rohrs R als Wandung bzw. Begrenzung. Von der Oberfläche A des Rohrs R und der innen liegenden Seite des Einströmkörpers K wird dabei der Spalt B ausgebildet. Auch somit ist eine Trennung der hier dargestellten beiden Gasrohre G1 und G2 möglich. Angedeutet ist die Möglichkeit mehrerer Gaseinlässe C sowie einer zentral angeordneten Messkammer C sowie diese flankierende Gaseinlässe H1 und H2. Insofern ist die Ausführungsform gemäß Figur 17 sowohl rotationssymmetrisch (bezüglich des Mittelpunktes des Rohres bzw. des Einströmkörpers K) als auch spiegelsymmetrisch bezüglich der Messkammer C. Diese Ausführungsform stellt jedoch lediglich ein Beispiel für eine rotationssymmetrische Ausbildung der Gasschleusenanordnung dar, für den Einströmkörper K kommen auch alle anderen in den Figuren 2 bis 16 dargestellten Varianten der Ausbildung eines Einströmkörpers K in Frage.

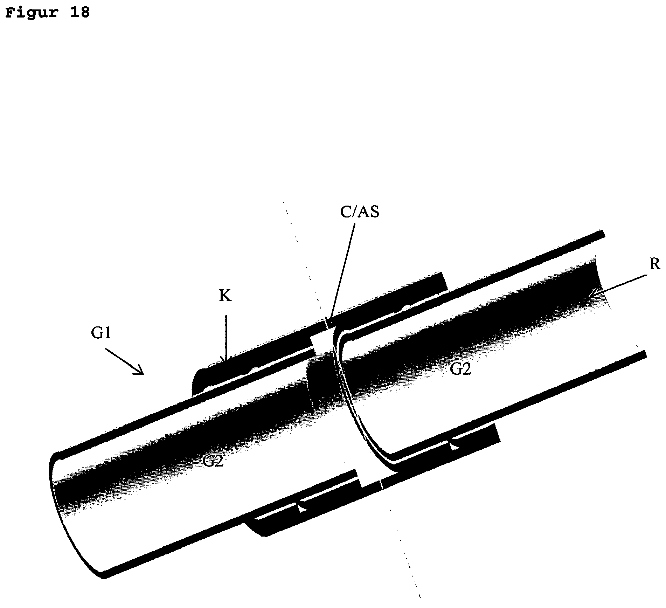

In Figur 18 ist eine Ausführungsform dargestellt, in der das Rohr R ca. in der Mitte liegend des Einströmkörpers K unterbrochen ist. In der in Figur 18 dargestellten Ausführungsform liegt diese Unterbrechung auf Höhe der Messkammer C bzw. der Möglichkeit der Absaugung AS. Für diesen Fall liegt der Gasraum G2 im Inneren des Rohres R, wobei die Gasräume G1 und G2 voneinander getrennt angeordnet sein können. Dies kann beispielsweise durch einen Verschluss des Rohres bewerkstelligt werden.

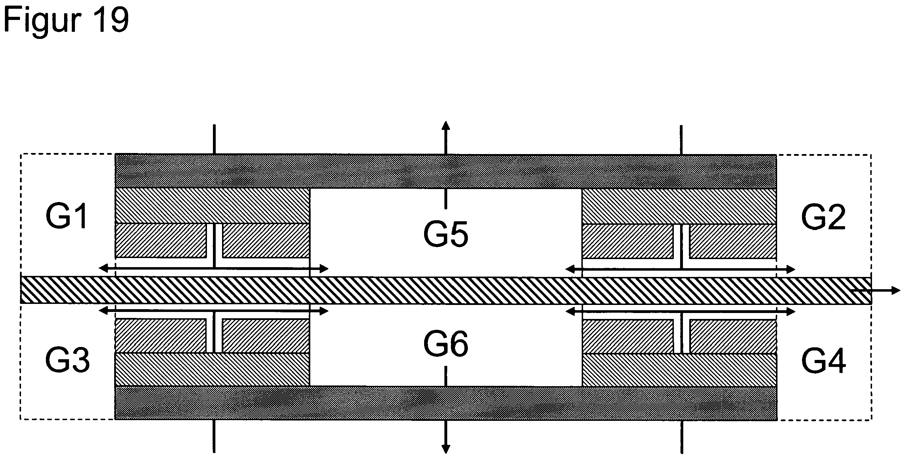

Figur 19 zeigt eine Beschichtungsvorrichtung gemäß der vorliegenden Erfindung, in die mehrere erfindungsgemäße Gasschleusen integriert sind. Aus Gründen der Übersichtlichkeit sind die erfindungsgemäßen Ausführungsformen der Gasschleusen in diesem Fall nicht dargestellt.

In einer ersten Ausführungsform besitzt die Beschichtungsvorrichtung zwei Beschichtungskammern G5 und G6, welche jeweils eine Absaugung besitzen (durch den Pfeil angedeutet). Diese Beschichtungskammern G5 und G6 können auf dem gleichen Druckniveau arbeiten, müssen dies jedoch nicht. Dargestellt ist ein Längsschnitt durch die Beschichtungsvorrichtung von der Seite. G1, G2, G3 und G4 können in diesem Fall die Umgebung darstellen, weshalb für die Drücke gilt:
P(G1) = P(G2) = P(G3) = P(G4). P(G5) kann größer oder kleiner als P(G1), P(G2), P(G3) oder P(G4) sein. Gleiches gilt für P(G6). Auf jeden Fall ist der Druck in allen vier Schleusen größer als P(G1), P(G2), P(G3), P(G4), P(G5) und P(G6). Damit ist der Gasraum G5 und der Gasraum G6 von der Umgebung getrennt.

Das Substrat kann nun kontinuierlich durch die Anlage bewegt werden (und zwar berührungsfrei), ohne die Gastrennung der Räume G5 und G6 zu verlieren (es muss aber nicht kontinuierlich bewegt werden). In dem gezeigten Fall würde das Substrat oben und unten beschichtet (es könnte aber auch einseitig beschichtet werden, hierfür müsste die Anlage nur den Teil oberhalb des Substrates (Beschichtung oben), bzw. unterhalb des Substrates (Beschichtung unten) aufweisen).

In einer zweiten Ausführungsform ist es jedoch ebenso denkbar, dass ein zylinderförmiges Substrat, beispielsweise ein Rohr, durch die dargestellte Beschichtungsvorrichtung geführt wird. In diesem Fall sind die Gasräume G1 und G3, G2 und G4 sowie G5 und G6 miteinander verbunden; es liegen in diesem Fall nur zwei Gasschleusen, die zylinderförmig um das Rohr ausgebildet sind, vor.

In jedem Fall sind die Gasschleusen jedoch wie voranstehend beschrieben erfindungsgemäß ausgebildet.

## Patentansprüche

1. Gasschleuse (I) zur Trennung zweier Gasräume (G1, G2), umfassend
a) mindestens einen Einströmkörper (K), der mindestens zwei Einlasskanäle (H1, H2) für ein Gas aufweist, die in eine erste Seite des Einströmkörpers (K) münden,
b) eine beabstandet zur ersten Seite des mindestens einen Einströmkörpers (K) angeordnete Wandung (A), wobei zwischen der Wandung (A) und dem mindestens einen Einströmkörper (K) ein Spalt (B), der in fluidischer Verbindung mit den mindestens zwei Einlasskanälen (H1, H2) steht, ausgebildet ist,
c) mindestens zwei Ausströmöffnungen (i1, i2) für das Gas, die in fluidischer Verbindung mit dem Spalt (B) stehen,
wobei in der den mindestens einen Einströmkörper (K) begrenzenden ersten Seite und/oder in der der ersten Seite des Einströmkörpers (K) zugewandten Seite der Wandung (A) n Messkammern (C1, C2, ... Cn) zur Messung mindestens einer physikalischen und/oder chemischen Eigenschaft des Gases vorhanden sind, wobei n eine ganze Zahl ≥ 2 ist,
**dadurch gekennzeichnet,**
**dass** jede Messkammer auf jeder Seite von mindestens einem Einlasskanal (H1, H2, ... H2n) flankiert ist, wobei je zwischen dem mindestens einen, eine Messkammer (Cn) flankierenden Einlasskanal (Hx) und dem diesem Einlasskanal (Hx) benachbarten Einlasskanal (Hx+1), der eine benachbarte Messkammer (Cn+1) flankiert, eine Möglichkeit zur Absaugung (AS1, AS2, ... AS(n-1)) vorgesehen ist.

2. Gasschleuse (I) nach Anspruch 1, **dadurch gekennzeichnet, dass** in der den mindestens einen Einströmkörper (K) begrenzenden ersten Seite und/oder in der der ersten Seite des Einströmkörpers (K) zugewandten Seite der Wandung (A) mindestens eine weitere, bevorzugt mindestens zwei weitere Messkammern (D1, D2) zur Messung mindestens einer physikalischen und/oder chemischen Eigenschaft des Gases vorhanden ist.

3. Gasschleuse (I) nach einem der vorhergehenden Ansprüche, **dadurch gekennzeichnet, dass** die den mindestens einen Einströmkörper (K) begrenzende erste Seite und/oder die der ersten Seite des Einströmkörpers (K) zugewandte Seite der Wandung (A) mindestens eine, bevorzugt eine Mehrzahl von der ersten Seite des Einströmkörpers ausgehende und in diesen hineinragende bzw. von der der ersten Seite des Einströmkörpers (K) zugewandten Seite der Wandung (A) ausgehende und in die Wandung (A) hineinragende Aussparungen (E) aufweist.

4. Gasschleuse (I) nach einem der vorhergehenden Ansprüche, **dadurch gekennzeichnet, dass** die den mindestens einen Einströmkörper (K) begrenzende erste Seite und/oder die der ersten Seite des Einströmkörpers (K) zugewandte Seite der Wandung (A) mindestens eine, bevorzugt eine Mehrzahl von der ersten Seite des Einströmkörpers ausgehende und in den Spalt (B) hineinragende bzw. von der der ersten Seite des Einströmkörpers (K) zugewandten Seite der Wandung (A) ausgehende und in den Spalt (B) hineinragende Erhebungen (F) aufweist.

5. Gasschleuse (I) nach den beiden vorhergehenden Ansprüchen, **dadurch gekennzeichnet, dass** mindestens eine Aussparung (E) und mindestens eine Erhebung (F) vorhanden sind.

6. Gasschleuse (I) nach einem der vorhergehenden Ansprüche, **dadurch gekennzeichnet, dass** sie bezüglich der Messkammer (C) spiegelsymmetrisch und/oder bezüglich einer parallel zur Gasschleuse verlaufenden Achse rotationssymmetrisch aufgebaut ist.

7. Gasschleuse (I) nach einem der vorhergehenden Ansprüche, **dadurch gekennzeichnet, dass** die Ausströmöffnungen (i1, i2) so angeordnet sind, dass die Ausströmrichtung der ersten Ausströmöffnung (i1) der Ausströmrichtung der zweiten Ausströmöffnung entgegengesetzt ist.

8. Gasschleuse (I) nach einem der vorhergehenden Ansprüche, **dadurch gekennzeichnet, dass** der Spalt (B) im Wesentlichen lotrecht zum mindestens einen Einlasskanal (H) verläuft.

9. Gasschleuse (I) nach einem der vorhergehenden Ansprüche, **dadurch gekennzeichnet, dass** mindestens eine Möglichkeit zum Absaugen von Gas (AS) vorhanden ist.

10. Gasschleuse (I) nach einem der vorhergehenden Ansprüche, **dadurch gekennzeichnet, dass** auf der dem Einströmkörper (K) abgewandten Seite der Wandung (A)
a) mindestens ein weiterer Einströmkörper (K') angeordnet ist, oder
b) eine Mehrzahl von abwechselnd angeordneten Einströmkörpern (K', K", ..., Kn) und Platten (A2, A3, ... An-1) angeordnet ist.

11. Beschichtungsvorrichtung oder Wärmebehandlungsvorrichtung, umfassend mindestens eine Gasschleuse nach einem der vorhergehenden Ansprüche.

12. Verwendung einer Gasschleuse nach einem der Ansprüche 1 bis 10 zur Aufrechterhaltung eines bestehenden Konzentrationsgradienten eines und/oder mehrerer Gase und/oder zur Aufrechterhaltung einer Separierung verschiedener Gase in den zwei Gasräumen (G1, G2).

## Claims

1. Gas lock (I) for separating two gas chambers (G1, G2), comprising
a) at least one inflow body (K), which has at least two inlet passages (H1, H2) for a gas, which open out into a first side of the inflow body (K),
b) a wall (A) which is arranged at a distance from the first side of the at least one inflow body (K), wherein a gap (B), which is in fluid communication with the at least two inlet passages (H1, H2), is formed between the wall (A) and the at least one inflow body (K),
c) at least two outflow openings (i1, i2) for the gas, which are in fluid communication with the gap (B),
wherein in the first side, delimiting the at least one inflow body (K), and/or in the side of the wall (A) that is facing the first side of the inflow body (K) there are at least n measuring chambers (C1, C2, ... Cn) for measuring at least one physical and/or chemical property of the gas, where n is a whole number ≥ 2,
**characterized in that**
each measuring chamber is flanked on each side by at least one inlet passage (H1, H2, ... H2n), wherein a possibility for suction removal (AS1, AS2, ... AS(n-1)) is respectively provided between the at least one measuring passage (Hx) flanking a measuring chamber (Cn) and the measuring passage (Hx+1) neighbouring this measuring passage (Hx), which flanks a neighbouring measuring chamber (Cn+1).

2. Gas lock (I) according to claim 1, **characterized in that** in the first side, delimiting the at least one inflow body (K), and/or in the side of the wall (A) that is facing the first side of the inflow body (K) there is at least one further measuring chamber, preferably at least two further measuring chambers (D1, D2), for measuring at least one physical and/or chemical property of the gas.

3. Gas lock (I) according to one of the preceding claims, **characterized in that** the first side, delimiting the at least one inflow body (K), and/or the side of the wall (A) that is facing the first side of the inflow body (K) has at least one recess, preferably a plurality of recesses (E), extending from the first side of the inflow body and protruding into said body or extending from the side of the wall (A) that is facing the first side of the inflow body (K) and protruding into the wall (A).

4. Gas lock (I) according to one of the preceding claims, **characterized in that** the first side, delimiting the at least one inflow body (K), and/or the side of the wall (A) that is facing the first side of the inflow body (K) has at least one elevation, preferably a plurality of elevations (F), extending from the first side of the inflow body and protruding into the gap (B) or extending from the side of the wall (A) that is facing the first side of the inflow body (K) and protruding into the gap (B).

5. Gas lock (I) according to the two preceding claims, **characterized in that** there is at least one recess (E) and at least one elevation (F).

6. Gas lock (I) according to one of the preceding claims, **characterized in that** it is constructed mirror-symmetrically with respect to the measuring chamber (C) and/or rotationally symmetrically with respect to an axis extending parallel to the gas lock.

7. Gas lock (I) according to one of the preceding claims, **characterized in that** the outflow openings (i1, i2) are arranged such that the outflow direction of the first outflow opening (i1) is opposed to the outflow direction of the second outflow opening.

8. Gas lock (I) according to one of the preceding claims, **characterized in that** the gap (B) extends essentially perpendicularly in relation to the at least one inlet passage (H).

9. Gas lock (I) according to one of the preceding claims, **characterized in that** there is at least one possibility for the suction removal of gas (AS).

10. Gas lock (I) according to one of the preceding claims, **characterized in that** on the side of the wall (A) that is facing away from the inflow body (K)
a) at least one further inflow body (K') is arranged or
b) a plurality of alternately arranged inflow bodies (K', K", ..., Kn) and plates (A2, A3, ... An-1) are arranged.

11. Coating device or heat treatment device, comprising at least one gas lock according to one of the preceding claims.

12. Use of a gas lock according to one of claims 1 to 10 for maintaining an existing concentration gradient of one and/or more gases and/or for maintaining a separation of different gases in the two gas chambers (G1, G2).

## Revendications

1. Ecluse à gaz (I) destinée à séparer deux compartiments à gaz (G1, G2), comprenant
a) au moins un corps d'admission de flux (K) qui présente au moins deux canaux d'entrée (H1, H2) pour un gaz qui débouchent dans un premier côté du corps d'admission de flux (K),
b) une paroi (A) disposée à distance du premier côté du corps d'admission de flux (K) au moins au nombre de un, un interstice (B) qui est en liaison fluidique avec les canaux d'entrée (H1, H2) au moins au nombre de deux étant constitué entre la paroi (A) et le corps d'admission de flux (K) au moins au nombre de un,
c) au moins deux ouvertures d'évacuation de flux (i1, i2) pour le gaz qui sont en liaison fluidique avec l'interstice (B),
n chambres de mesure (C1, C2, ... Cn) destinées à mesurer au moins une caractéristique physique et/ou chimique du gaz étant présentes dans le premier côté limitant le corps d'admission de flux (K) au moins au nombre de un et/ou dans le côté de la paroi (A) tourné vers le premier côté du corps d'admission de flux (K), n étant un nombre entier ≥ 2,
**caractérisée en ce que**
chaque chambre de mesure est de chaque côté flanquée d'au moins un canal d'entrée (H1, H2, ... H2n), une possibilité d'aspiration (AS1, AS2, ... AS(n-1)) étant prévue respectivement entre le canal d'entrée (Hx) au moins au nombre de un flanquant une chambre de mesure (Cn) et le canal d'entrée (Hx+1) qui est voisin de ce canal d'entrée (Hx) et qui flanque une chambre de mesure (Cn+1) voisine.

2. Ecluse à gaz (I) selon la revendication 1, **caractérisée en ce que**, dans le premier côté limitant le corps d'admission de flux (K) au moins au nombre de un et/ou dans le côté de la paroi (A) tourné vers le premier côté du corps d'admission de flux (K), au moins une autre, de préférence au moins deux autres chambres de mesure (D1, D2) sont présentes pour la mesure d'au moins une caractéristique physique et/ou chimique du gaz.

3. Ecluse à gaz (I) selon l'une des revendications précédentes, **caractérisée en ce que** le premier côté limitant le corps d'admission de flux (K) au moins au nombre de un et/ou le côté de la paroi (A) tourné vers le premier côté du corps d'admission de flux (K) présente au moins une ou de préférence une pluralité d'évidements (E) partant du premier côté du corps d'admission de flux et pénétrant dans ce corps, ou respectivement partant du côté de la paroi (A) tourné vers le premier côté du corps d'admission de flux (K) et pénétrant dans la paroi (A).

4. Ecluse à gaz (I) selon l'une des revendications précédentes, **caractérisée en ce que** le premier côté limitant le corps d'admission de flux (K) au moins au nombre de un et/ou le côté de la paroi (A) tourné vers le premier côté du corps d'admission de flux (K) présente une ou de préférence une pluralité de surélévations (F) partant du premier côté du corps d'admission de flux et pénétrant dans l'interstice (B), ou respectivement partant du côté de la paroi (A) tourné vers le premier côté du corps d'admission de flux (K) et pénétrant dans l'interstice (B).

5. Ecluse à gaz (I) selon les deux revendications précédentes, **caractérisée en ce qu'**il y a au moins un évidement (E) et au moins une surélévation (F).

6. Ecluse à gaz (I) selon l'une des revendications précédentes, **caractérisée en ce qu'**elle est construite en symétrie miroir par rapport à la chambre de mesure (C) et/ou de façon symétrique en rotation par rapport à un axe qui est parallèle à l'écluse à gaz.

7. Ecluse à gaz (I) selon l'une des revendications précédentes, **caractérisée en ce que** les ouvertures d'évacuation de flux (i1, i2) sont disposées de telle sorte que le sens d'évacuation de flux de la première ouverture d'évacuation de flux (i1) est opposé au sens d'évacuation de flux de la deuxième ouverture d'évacuation de flux.

8. Ecluse à gaz (I) selon l'une des revendications précédentes, **caractérisée en ce que** l'interstice (B) est essentiellement perpendiculaire au canal d'entrée (H) au moins au nombre de un.

9. Ecluse à gaz (I) selon l'une des revendications précédentes, **caractérisée en ce qu'**il existe au moins une possibilité d'aspiration de gaz (AS).

10. Ecluse à gaz (1) selon l'une des revendications précédentes, **caractérisée en ce que**, sur le côté de la paroi (A) éloigné du corps d'admission de flux (K),
a) il est disposé au moins un autre corps d'admission de flux (K'), ou
b) il est disposé une pluralité de corps d'admission de flux (K', K", ..., Kn) et de plaques (A2, A3, ... An-1) disposés de façon alternée.

11. Dispositif de revêtement ou dispositif de traitement thermique, comprenant au moins une écluse à gaz selon l'une des revendications précédentes.

12. Utilisation d'une écluse à gaz selon l'une des revendications 1 à 10 pour le maintien d'un gradient de concentration existant d'un et/ou de plusieurs gaz et/ou pour le maintien d'une séparation de différents gaz dans les deux compartiments à gaz (G1, G2).
